# EUROPEAN PATENT APPLICATION

(11) **EP 4 642 186 A1**
(43) Date of publication of application: **29.10.2025**
(21) Application number: 25171238.6
(22) Date of filing: 17.04.2025
(51) Int. Cl.: H10D 62/85, H10B 20/25, H10D 30/01, H10D 30/47

(54) **ONE TIME PROGRAMMABLE MEMORY DEVICE IN MONOLITHIC GAN TECHNOLOGY**

(30) Priority: 22.04.2024 IT 202400009157
(71) Applicant: STMicroelectronics International N.V., 1228 Plan-les-Ouates, Geneva (CH)
(72) Inventor: BARDELLI, Roberto Giorgio, 22073 Fino Mornasco (CO) (IT); MARCHESI, Marco, 20011 Corbetta (MI) (IT); ROSSI, Sandro, 27100 Pavia (IT); GAMBERO, Andrea, 20010 Santo Stefano Ticino (MI) (IT); SICURELLA, Giovanni, 95125 Catania (IT); MARRELLA, Michele, 95047 Paternò (CT) (IT)
(74) Representative: Studio Torta S.p.A.

(57) **Abstract**

A One Time Programmable (OTP) memory device includes a semiconductor die (10) and a one time programmable, OTP, memory cell (1) integrated into the die (10). The die (10; 101) includes a channel layer (12) and a barrier layer (13) forming a heterostructure (15) and a plurality of metallization levels (M1-M5) over the heterostructure (15). The OTP memory cell (1) includes a fuse element (2), having a low impedance value in a native unprogrammed state and a second impedance value in a programmed state, where the first impedance value is lower than the second impedance value; and a selector (3) coupled in series to the fuse element (2) and operable to cause the flow of a write current (IW) which brings the fuse element (2; 40) from the unprogrammed state to the programmed state in an irreversible manner. The fuse element (2) is formed in one of the metallization levels (M1-M5) of the die (10). The selector (3) includes a High Electron Mobility Transistor (HEMT) at least partly formed in the heterostructure (15).

## Description

### Technical Field

The present invention relates to a one time programmable memory device in monolithic GaN technology.

### Background

As is known, many integrated circuits comprise functional blocks for trimming, with the aim of compensating for process dispersions or parameter drifts which may affect, for example, reference voltages, oscillators and operational amplifiers. Functional blocks generally comprise banks of components, such as capacitors or resistors, that may be connected in various configurations to obtain desired compensation values. Functional blocks of this type are particularly useful in devices in GaN (gallium nitride) technology, which is extremely promising in terms of performances, but is not yet mature.

In many cases, the configuration of the components that form a trimming functional block is determined using arrays of a one time programmable read-only memory, also called OTP (One Time Programmable) memories. In practice, each memory cell is associated with a specific component of the trimming block and the state of the cell determines the connection or disconnection of the respective component.

While in traditional silicon semiconductor devices the integration of various types of memories, including OTP memories, no longer poses significant problems, for devices in GaN technology it is still necessary to resort to external OTP memories, which are encapsulated in a same package together with the main device. However, the use of external OTP memories may represent a limit in terms of performances, size and costs.

### Summary

It is therefore the aim of the present invention to provide a one time programmable memory device which allows the limitations described to be overcome or at least mitigated.

According to the present invention, a one time programmable memory device is provided as defined in claim 1.

### Brief Description of the Figures

For a better understanding of the present invention, preferred embodiments are provided, by way of non-limiting example, with reference to the attached drawings, wherein:
- Figure 1 is a simplified circuit diagram of an OTP memory device in accordance with an embodiment of the present invention;
- Figure 2 is a cross-section through the OTP memory device of Figure 1;

- Figure 3 is a simplified plan view of a portion of the OTP memory device of Figure 1;
- Figure 4 is a cross-section through an OTP memory device in accordance with a different embodiment of the present invention;
- Figure 5 is a simplified plan view of a portion of the OTP memory device of Figure 4;
- Figure 6 is a simplified block diagram of an OTP memory in accordance with an embodiment of the present invention;
- Figure 7 is a more detailed block diagram of a first component of the OTP memory of Figure 6;
- Figure 8 is a more detailed block diagram of a part of the component of Figure 7;
- Figure 9 is a more detailed block diagram of a second component of the OTP memory of Figure 6; and
- Figures 10-12 are examples of circuit diagrams relating to components of the OTP memory of Figure 6.

### Description of Embodiments

The following description refers to the arrangement shown in the drawings; consequently, expressions such as "above", "below", "upper", "lower", "top", "bottom", "right", "left" and similar relate to the attached Figures and are not to be interpreted in a limiting manner.

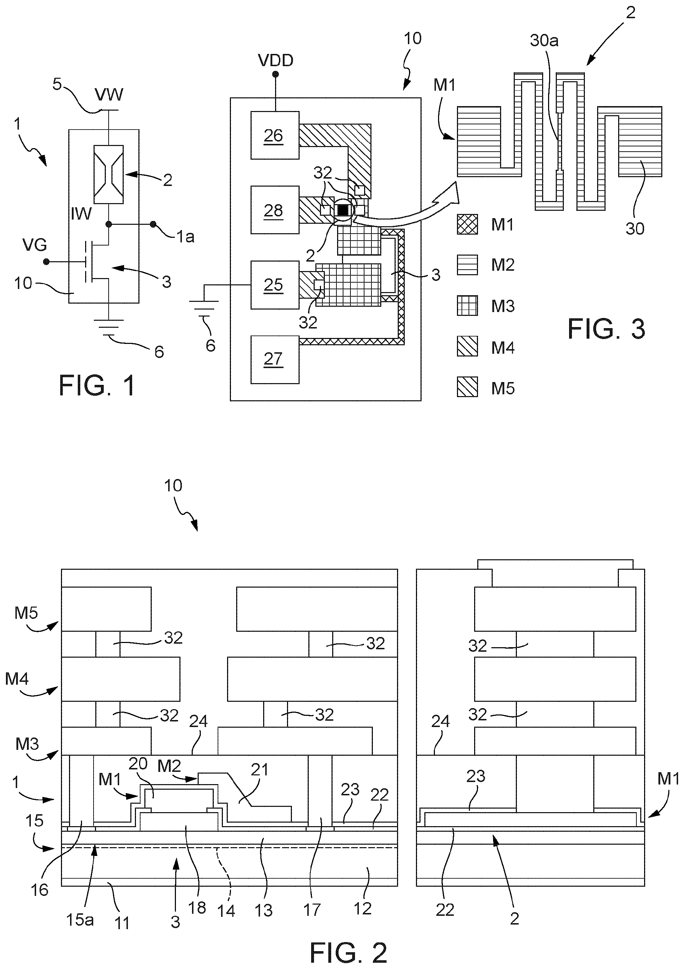

With reference to Figure 1, a one time programmable memory device or OTP (One time Programmable) memory device, in particular an OTP memory cell, is indicated as a whole with the number 1 and comprises a fuse element 2 and a selector 3, both integrated into a semiconductor die 10. The fuse element 2 and the selector 3 are connected in series between a first line at a constant potential, for example a write line 5 at a write voltage VW, and a second line at a constant potential, for example a ground line 6 or a supply line at a negative voltage.

The fuse element 2 is of the type having a first impedance value in an unwritten or native unprogrammed state and a second impedance value in a written or programmed state, where the first impedance value is lower than the second impedance value. For example, the first impedance value has a value of at least two orders of magnitude, such as three orders of magnitude, lower than the second impedance value.

The selector 3 is defined by an enhancement High Electron Mobility Transistor or HEMT (enhancement HEMT), i.e. of the normally-off type. The selector 3 is operable by a driving circuit not shown in Figure 1 to cause a write current IW to flow and bring the fuse element from the unprogrammed state to the programmed state in an irreversible manner (for example by electromigration).

An intermediate node between the fuse element 2 and the selector 3 defines an output terminal 1a of the OTP memory cell 1.

Figures 2 and 3 show a portion of a semiconductor die 10 wherein the OTP memory cell 1 is integrated. The die 10 comprises a substrate 11 having mechanical support function and/or electrical functions, for example of silicon or silicon carbide, a channel layer 12 and a barrier layer 13. The channel layer 12 and the barrier layer 13 are of respective semiconductor materials with different bandgaps and form a heterostructure 15, with a heterojunction 15a at a common interface. For example, the channel layer 12 is of intrinsic gallium nitride (GaN), while the barrier layer 13 is of aluminum gallium nitride (AlGaN) and has N-type conductivity. A 2-Dimensional Electron Gas (2DEG) 14 is formed in a channel region of the channel layer 12 at the heterojunction 15a.

The die 10 further comprises a plurality of metallization levels, each of which having respective conductive structures formed therein, as detailed below.

The selector 3 is formed in a first portion of the die 10 and comprises a source contact 16, a drain contact 17, a gate region 18, a gate metallization structure 20 and a source field plate 21. The gate region 18 is of gallium nitride doped to have P-type conductivity (pGaN). The gate region 18, based on the voltage applied thereto, modulates the thickness of the conductive channel that forms at the interface between the channel layer 12 and the barrier layer 13 and ensures the operation in the "normally-off" mode of the HEMT device forming the selector 3. The gate metallization structure 20 is obtained in a first one of the metallization levels, also referred to as gate metallization level and here indicated by M1.

The source field plate 21 is formed in a second one of the metallization levels, also referred to as field plate metallization level and here indicated by M2, and extends partly over the gate metallization structure 20 and partly on the barrier layer 13 between the gate region 18 and the drain contact 17.

A dielectric structure that includes a first dielectric layer 22 and a second dielectric layer 23 covers the heterostructure 15, the gate region 18 and the gate metallization structure 20 and provides insulation from the source field plate 21. More specifically, the first dielectric layer 22 is formed on the heterostructure 15 and covers sides of the gate region 18, leaving the gate metallization structure 20 exposed. The second dielectric layer 23 is formed on the first dielectric layer 22, coats also the gate metallization structure 20 and separates the source field plate 21 from the gate metallization structure 20. Thus, the whole dielectric structure defined by the first dielectric layer 22 and the second dielectric layer 23 coats the gate region 18 and the gate metallization structure 20 and insulates the gate region 18 and the gate metallization structure 20 from the source field plate 21.

The fuse element 2 is formed in a second portion of the die 10 and, in particular, in one embodiment it is formed in the gate metallization level M1, like the gate metallization structure 20. The fuse element 2 is in contact with a portion of the first dielectric layer 22 and is coated by the second dielectric layer 23. Therefore, the fuse element 2 is separated from heterostructure 15 the by the first dielectric layer 22 and, except for intermetallic vias for providing electrical coupling, is fully encapsulated in dielectric material. Moreover, the fuse element 2 is away from and not in contact with doped gallium nitride (pGaN) forming the gate region 18. Advantageously, the presence of dielectric all around the fuse element 2 and the distance from doped gallium nitride regions reduce heat dissipation and favour rapid temperature increase. Dielectric materials, in fact, provide better thermal insulation than doped gallium nitride. As a result, the fuse element 2 may be broken by a lower current and/or in a shorter time. From another standpoint, programming operations are made more reliable, given the same programming current.

A third dielectric layer 24 covers the first dielectric layer 22, the second dielectric layer 23, the gate region 18, the gate metallization structure 20 and the source field plate 21.

The metallization levels of the die 10 further include a plurality of routing metallization levels at respective distances from a surface of the barrier layer over the source contact 16 and the drain contact 17 of the selector 3. In the embodiment described, in particular, the die 10 has three routing metallization levels indicated respectively by M3, M4 and M5. In the routing metallization levels M3-M5 routing structures are formed, in particular, for high voltages and currents. The number of routing metallization levels shown is purely exemplary and not limiting of the present invention.

With reference to Figure 3, for example, the die 10 comprises, for the OTP memory cell 1, a source pad 25, connected to the ground line 6 and set at a reference voltage, a drain pad 26, set at a supply voltage VDD, a gate pad 27, receiving a control voltage VG from a control unit external to the die 10 and not shown here, and a write pad 28, connected to the write line 5 and set at the write voltage VW. The source pad 25 and the drain pad 26 are connected respectively to the source contact 16 and to the drain contact 17 through portions of the routing metallization levels M3-M5. The gate pad 27 is connected to the gate region 18 through the metallization structure 20 in the gate metallization level M1. The write pad 28 is connected to the drain contact 17 through portions of the routing metallization levels M3-M5 and the fuse element 2, which, as already mentioned, in the embodiment of Figures 2 and 3 is formed in the gate metallization level M1. In particular, as better visible in the enlarged detail of Figure 3, the fuse element 2 comprises a narrowing along a conductive track 30 of the gate metallization level M1 which connects the write line 5 (not shown here for simplicity) to the selector 3. In the example of Figure 3, the fuse element 2 extends along a serpentine path and, generally, has a length and a width selected to break at a desired time in response to the flow of a given write current. In order to improve control of break location and timing, the conductive track 30 may have a further narrowing 30a, which has the lowest width in the conductive track 30. The further narrowing 30a may be located at an intermediate portion of the conductive track 30, e.g. at the center. The number, width and length of straight portions and turns of the serpentine path may be selected in accordance with design preferences.

The connections between the metallization levels of the die 10 are formed by intermetallic vias 32 in accordance with design preferences.

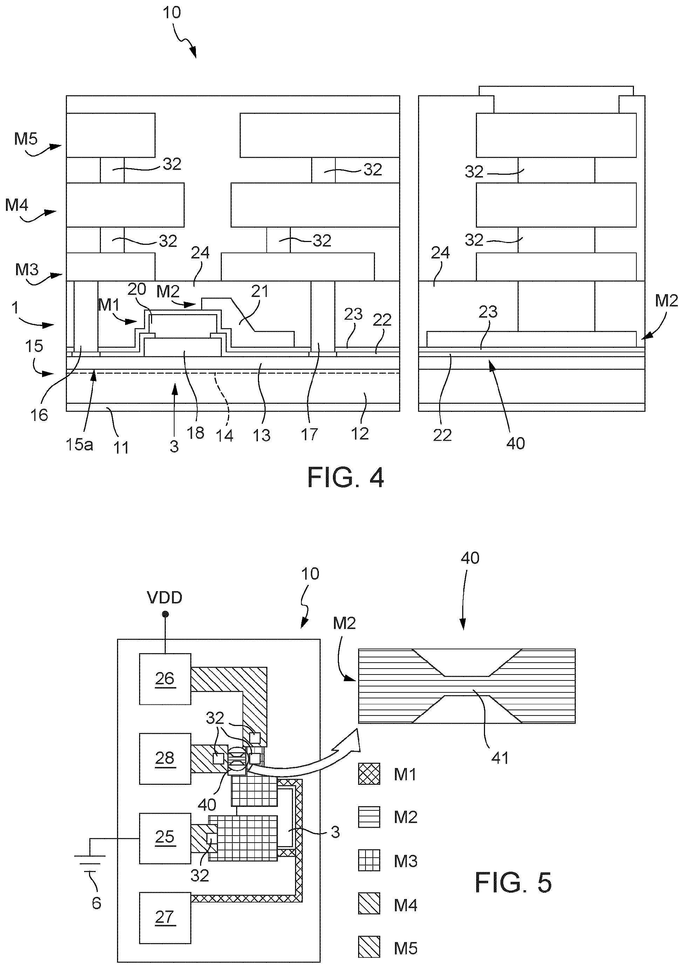

In the embodiment of Figures 4 and 5, where parts identical to those already shown are indicated with the same reference numerals, the fuse element, here indicated by 40, is formed in the field plate metallization level M2, where the source field plate 21 is also formed. In this case, the fuse element 40 comprises a narrowing along a conductive track 41 which connects, together with portions of the routing metallization levels M3-M5, the write pad 28 and the drain contact 17. In the embodiment of Figures 4 and 5, the fuse element 40 is rectilinear.

As illustrated in figure 4, the fuse element 40 is formed on the second dielectric layer 22 and is embedded in the third dielectric layer 24, that encloses also the gate region 18, the gate metallization structure 20 and the source field plate 21. Therefore, also in this case the fuse element 40 benefits from high thermal insulation of the dielectric material all around and from being not in contact with the doped gallium nitride, which would favour heat dissipation. In addition, the field plate metallization level M2 is normally thinner than the gate metallization level M1 and the routing metallization levels M3-M5 and has greater resistivity, so that breaking the fuse element 40 proves easier. For example, the thickness of the field plate metallization level M2 may be 85 nm, while the thickness of the gate metallization level M1 may be 270 nm. Therefore, the fuse element 40 has further advantages in terms of power consumption, programming time and reliability.

In principle, the fuse element may also be formed in the upper metallization levels M3-M5 (or generally M3-MN). However, the gate metallization level M1 and the field plate metallization level M2 have the advantage of being much thinner and therefore having greater resistivity, thus allowing the formation of fuse elements programmable with lower write currents or, with the same write current, having smaller size.

It is also understood that the shape of the fuse element, in particular of the narrowings, may be arbitrarily chosen in accordance with design preferences.

The OTP memory cell described may be advantageously included in a system in monolithic GaN technology, i.e. in a system comprising GaN-HEMT devices and auxiliary components monolithically integrated in the same die. The invention therefore allows the transition from the so-called Systems In Package, wherein discrete or in any case non-monolithic components are assembled in a same package, towards Systems On Chip, wherein the components are integrated in the same semiconductor support and which have advantages in terms of performances, size and costs.

In the field of Systems On Chip in monolithic GaN technology, OTP memory cells may be used for different purposes.

For example, a bank of OTP memory cells may be used to permanently store a unique code for identification and tracking purposes.

OTP memory cells may also be used to permanently configure integrated devices. In particular, some series of integrated devices which share a basic architecture and differ in a limited number of functions may be produced using a same manufacturing process. Functional blocks integrated into all devices in the series may be configured downstream of manufacturing by OTP memory cells to specialize their functions according to use. In this manner, diversifying manufacturing processes due to ultimately marginal variations between devices in the series is not necessary. For example, designing different masks for only a few details is not necessary.

Another extremely advantageous use relates to the integration of OTP memory arrays for trimming integrated circuits to compensate for process dispersions or parameter drifts which may affect, for example, reference voltages and currents, oscillator frequencies and operational amplifier offsets.

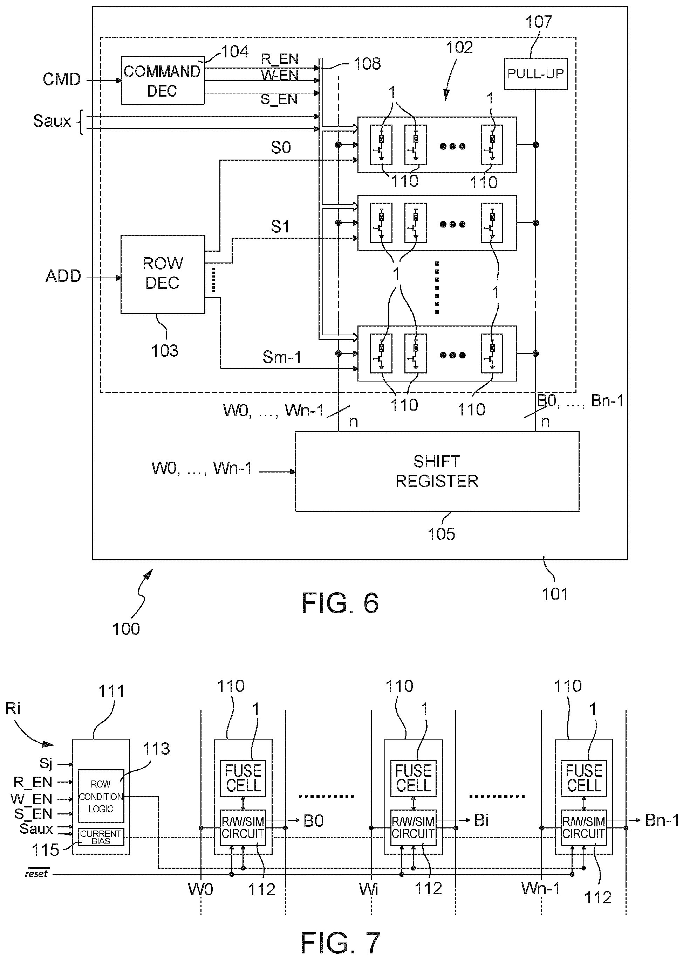

With reference to Figure 6, in one embodiment a one time programmable read-only memory or OTP memory 100 is integrated into a die 101 having the same structure as the die 10 of Figures 2 and 3 and comprising, in particular, a channel layer of gallium nitride (GaN), a barrier layer of aluminum gallium nitride (AlGaN) with N-type conductivity and a plurality of metallization levels, not shown here for simplicity.

The OTP memory 100 comprises a memory array 102, a row decoder 103, a command decoder 104, a shift register 105, a pull-up circuit 107 and a local bus 108. All components are made by using monolithic GaN technology and are based on enhancement or depletion HEMTs, in accordance with design preferences.

The memory array 102 contains a plurality of bit units 110 arranged in rows R0, ..., Rm-1, selectively addressable through the row decoder 103 by row selection signals S0, ..., Sm-1. Each row R0, ..., Rm-1 comprises a number n of bit units 110. Each bit unit 110 comprises a respective OTP memory cell, for example like the OTP memory cell 1 of Figures 2 and 3, as explained in more detail hereinbelow.

The row decoder 103 (optional in case only one row of bit units 110 is present) selectively activates one of the rows R0, ..., Rm-1 for write, read or write simulation operations in response to addresses RADD received from an external processing unit, not shown.

The command decoder 104 (optional) receives commands CMD from the external processing unit and provides global enable signals W_EN, R_EN, S_EN through the local bus 108 for write, read and write simulation operations. The global enable signals may include a global write signal W_EN, a global read signal R_EN, and, optionally, a global write simulation signal S_EN.

The local bus 108 is further used to distribute auxiliary signals Saux useful for managing write, read and write simulation operations and not described in detail herein.

The shift register 105, having a length n equal to the number of bit units 110 in each of the rows R0, ..., Rm-1, allows the serial loading of write data WO, ..., Wn-1 to be written into the memory array 102 and the parallel loading of data read from the memory array 102. More precisely, when the command decoder 104 sets one of the global write signal W_EN and the global write simulation signal S_EN at an active level for write or write simulation operations, the data serially preloaded into the shift register 105 are transferred to the row R0, ..., Rm-1 selected by the row decoder 103. Instead, when the command decoder 104 sets the global read signal R_EN at the active level and a read operation of the row R0, ..., Rm-1 selected by the row decoder 103 is performed, the read data are loaded in a parallel manner into the shift register 105 and temporarily stored to be made available to the outside.

Figure 7 shows in more detail one of the rows R0, ..., Rm-1, for example a generic row Ri, which comprises n bit units 110 and an enable circuit 111. Each bit unit 110 comprises an OTP memory cell 1 and a read/write circuit 112, configured to perform read, write and, optionally, write simulation operations on the respective OTP memory cell 1.

The enable circuit 111 comprises a logic module 113 and a read bias circuit 115. The logic module 113 receives the respective row selection signal Sj from the row decoder 103, the enable signals W_EN, R_EN, S_EN from the command decoder 104 and, optionally, one or more of the auxiliary signals Saux through the local bus 108. The logic module 113 is configured to determine the operating conditions of the bit units 110, in particular of the read/write circuits 112, by a local read signal R_ENL, a local write signal W_ENL and a local write simulation signal S_ENL generated as a function of the enable signals W_EN, R_EN, S_EN and possibly of one or more of the auxiliary signals Saux, according to design preferences. The read bias circuit 115 provides a reference read current IWREF during read operations of the row Ri.

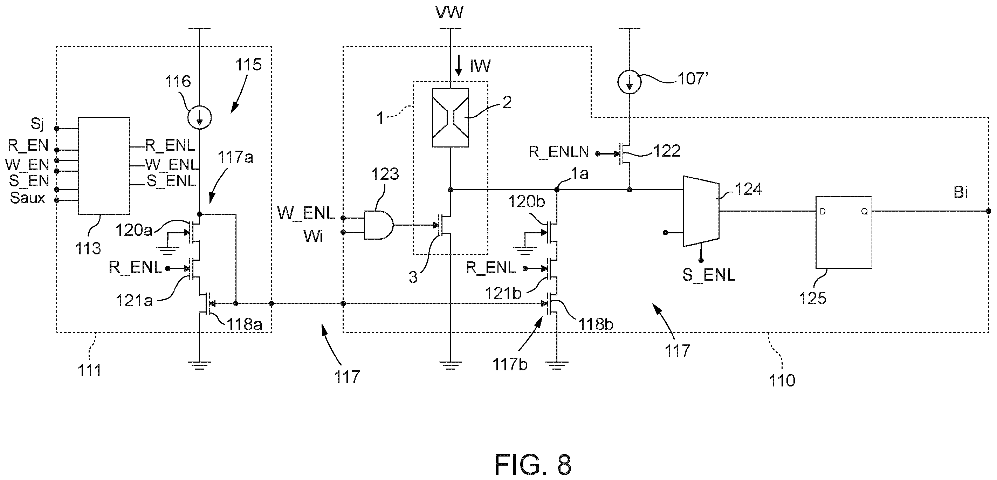

Figure 8 shows in more detail the read bias circuit 115 and one of the read/write circuits 112 of the row Ri.

The read bias circuit 115 comprises a reference current generator 116 and forms a read current mirror 117 with the read/write circuit 112 of each bit unit 110 of the row Ri. More precisely, the read bias circuit 115 comprises a reference branch 117a of the current mirror 117, which receives a read reference current IRW from the reference current generator 116. The read/write circuit 112 comprises a mirror branch 117b of the current mirror 117, connected to the output terminal 1a of the OTP memory cell 1. The branches 117a, 117b each comprise an enhancement HEMT 118a, 118b and a depletion HEMT 120a, 120b, in series with each other, and a read enable switch 121a, 121b, defined for example by a further enhancement HEMT and connected between the respective enhancement HEMT 118a, 118b and the respective depletion HEMT 120a, 120b. The enhancement HEMTs 118a, 118b form the current mirror proper and have a gate terminal in common and connected to the drain terminal of the depletion HEMT 120a of the reference branch 117a. The read enable switches 121a, 121b are controlled by the local read signal R_ENL provided by the logic module 113.

The read/write circuit 112 further comprises a pull-up switch 122, a write enable port 123, a multiplexer 124, and a latch circuit 125.

The pull-up switch 122 is controlled in phase-opposition with respect to the read enable switches 121a, 121b by a negated local read signal R_ENLN to connect the output terminal 1a of the OTP memory cell 1 to the pull-up circuit 107 when reading is not enabled.

The write enable port 123 controls the selector 3 as a function of the local write signal W_ENL and of a write datum Wi received from the shift register 105 during the write step. When the local write signal W_ENL enables writing and the write datum Wi is 1 (in the example described), the write enable port 123 turns on the selector 3 and allows the flow of the write current IW, which brings the fuse element 2 into the programmed state. The type of gate (AND, NAND, OR, NOR) is chosen based on the signal levels used, in accordance with design preferences.

The multiplexer 124 has inputs connected to the output terminal 1a of the OTP memory cell 1, to receive a read signal indicative of the state of the OTP memory cell 1 during the read step, and to a respective output of the shift register 105, to receive a write datum Wi during the write simulation step. An output of the multiplexer 124 is connected to the latch circuit 125. The datum passed from the multiplexer 124 to the latch circuit 125 is selected for example based on the local write simulation signal S_ENL. In particular, the multiplexer 124 is controlled to pass the write datum Wi during the write simulation step and the datum present on the output terminal 1a of the OTP memory cell 1 otherwise.

The latch circuit 125, for example a D-type flip-flop, provides an output datum Bi to the shift register 105. During the read step, the output datum Bi is representative of the state of the OTP memory cell 1, while during the write simulation step the output datum Bi is the write datum Wi.

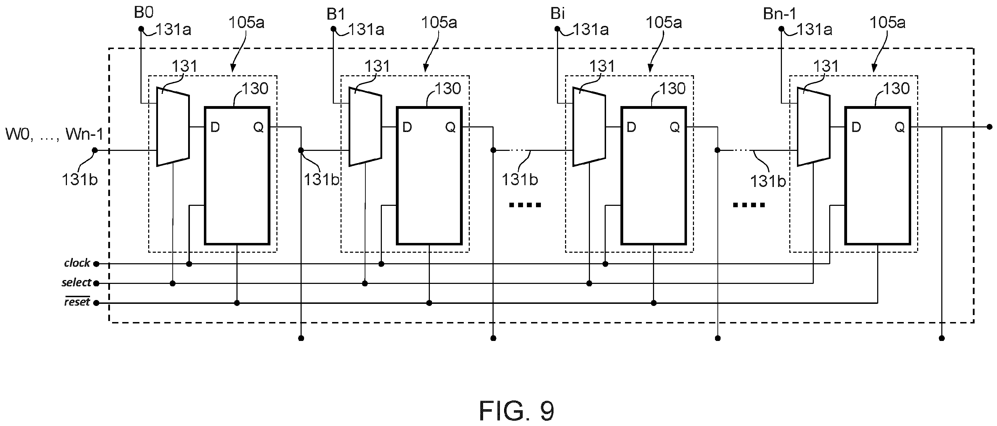

According to a non-limiting example illustrated in Figure 9, the shift register 105 comprises a number n of register units 105a, each of which includes a bistable element, for example a D-type master/slave flip-flop 130, and a multiplexer 131, connected in sequence. In detail, all the multiplexers 131 have a parallel input 131a, connected to a respective bit unit 110 to receive a respective output datum B0, ..., Bn-1, a serial input 131b and an output connected to a data input of the respective flip-flop 130. The multiplexer 131 is controlled by a selection signal SEL provided for example directly by an external processing unit not shown. In the first register unit 105a, i.e. the most upstream one in the sequence, the serial input 131b of the multiplexer 131 receives in succession write data WO, ..., Wn-1 to be loaded into the shift register 105 and to be written in one of the rows R0, ..., Rm-1 of the memory array 102. In the subsequent register units 105a, the serial input 131b of the multiplexer 131 is connected to a data output of the flip-flop 130 of the register unit 105a immediately upstream. The data outputs of the flip-flops 130 define an n-bit parallel output of the shift register 105, while the data output of the flip-flop 130 of the register unit 105a further downstream in the sequence defines a serial output.

The OTP memory 100 advantageously described may be entirely made by using monolithic GaN technology in a single die, owing in particular to the integration of the fuse element of each OTP memory cell in one of the metallization lines present in the same die.

The remaining components may be designed by using HEMT devices of a single type, in particular N-channel HEMT devices, which may be integrated into a single die. For example, circuits and logic gates may be implemented in resistance ratio logic.

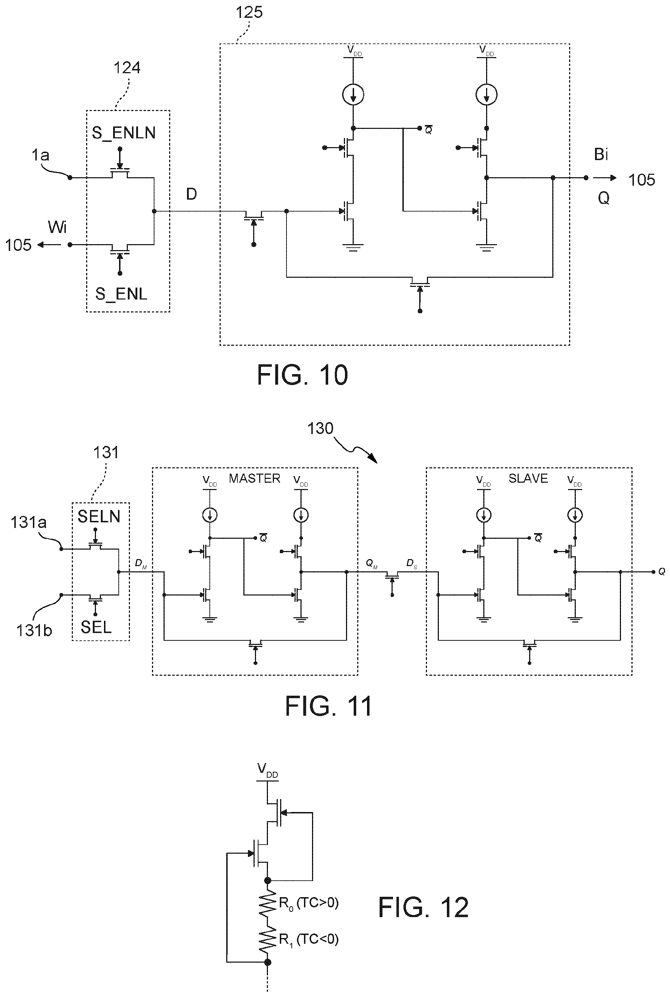

The multiplexer 124 and the latch circuit 125 may be formed as illustrated by way of example in Figure 10.

In each register unit 105a of the shift register 105, the flip-flop 130 and the multiplexer 131 may be formed as shown, again by way of non-limiting example, in Figure 11.

The current references may instead be provided as shown in the example of Figure 12, using two series-resistors, one having a negative temperature coefficient and one having a positive temperature coefficient, to obtain better stability in temperature, as well as with respect to variations in supply voltages.

Finally, it is clear that modifications and variations may be made to the OTP memory device described and illustrated herein without thereby departing from the scope of the present invention, as defined in the attached claims.

In one embodiment the memory device comprises a plurality of OTP memory cells 1 identical to each other integrated into the die 101.

In one embodiment the OTP memory cells 1 are arranged in rows R0, ..., Rm-1, each comprising a plurality of bit units 110 and an enable circuit 111, wherein each bit unit 110 comprises a respective one of the OTP memory cells 1 and a respective read/write circuit 112 configured to perform read and write operations on the respective OTP memory cell 1 and selectively operable by the enable circuit 111.

In one embodiment, in each row R0, ..., Rm-1, the enable circuit 111 comprises a read bias circuit 115 forming a read current mirror circuit 117 with the read/write circuit 112 of each bit unit 10.

In one embodiment, the enable circuit 111 defines a reference branch 117a of the read current mirror circuit 117, comprising a first enhancement HEMT 118a and a first depletion HEMT 120a in series with each other, wherein the read/write circuit 112 of each bit unit 110 defines a respective mirror branch 117b of the read current mirror circuit 117, coupled to an output 1a of the respective OTP memory cell 1 and comprising a second enhancement HEMT 118b and a second depletion HEMT 120b in series with each other, and wherein the first enhancement HEMT 118a and the second enhancement HEMT 118b have respective gate terminals in common and connected to a drain terminal of the first depletion HEMT 120a.

In one embodiment, the read current mirror circuit 117 comprises a first read enable switch 121a, defined by a further HEMT and connected between the first enhancement HEMT 118a and the first depletion HEMT 120a, and, for each bit unit 110 of the respective row R0, ..., Rm-1, a second read enable switch 121b, defined by a further HEMT and connected between the second enhancement HEMT 118b and the second depletion HEMT 120b of the respective mirror branch 117b.

In one embodiment, the memory device comprises a row decoder 103, a command decoder 104 and a shift register 105, all made by using GaN technology.

In one embodiment, in each row R0, ..., Rm-1, the enable circuit 111 comprises a logic module 113 configured to generate local enable signals W_ENL, R_ENL, S_ENL as a function of row selection signals S0, ..., Sm-1 provided by the row decoder 103 and global enable signals W_EN, R_EN, S_EN provided by the command decoder 104 and to determine an operating mode of the respective bit units 110 as a function of the local enable signals W_ENL, R_ENL, S_ENL.

In one embodiment each read/write circuit 112 comprises a respective write enable port 123 configured to control the selector 3 of the respective OTP memory cell 1 as a function of the local enable signals W_ENL, R_ENL, S_ENL and of a write datum Wi provided by the shift register 105.

In one embodiment the shift register 105 is coupled to each of the rows R0, ..., Rm-1 and is configured for serial loading of write data WO, ..., Wn-1 to be selectively written in an addressed one of the rows R0, ..., Rm-1 during a write operation and for parallel loading of output data B0, ..., Bn-1 read from an addressed one of the rows R0, ..., Rm-1 during a read operation.

## Claims

1. A One Time Programmable (OTP) memory device comprising:
a semiconductor die (10; 101);
a one time programmable (OTP) memory cell (1) integrated into the die (10; 101);
wherein the die (10; 101) comprises:
a channel layer (12) and a barrier layer (13) forming a heterostructure (15), with a heterojunction (15a) at an interface between the channel layer (12) and the barrier layer (13); and
a plurality of metallization levels (M1-M5) over the heterostructure (15);
wherein the OTP memory cell (1) comprises:
a fuse element (2;40) having a first impedance value in a native unprogrammed state and a second impedance value in a programmed state, where the first impedance value is lower than the second impedance value; and
a selector (3) coupled in series to the fuse element (2; 40) and operable to cause a write current (IW) to flow and irreversibly bring the fuse element (2; 40) from the unprogrammed state to the programmed state;
wherein the fuse element (2; 40) is formed in one of the metallization levels (M1-M5) of the die (10; 101); and
wherein the selector (3) comprises a High Electron Mobility Transistor (HEMT) at least partly formed in the heterostructure (15).

2. The device according to claim 1, wherein the selector (3) comprises a normally-off enhancement HEMT having a gate region (18) on the barrier layer (13).

3. The device according to claim 2, wherein the channel layer (12) is of intrinsic gallium nitride, the barrier layer (13) is of aluminum gallium nitride (AlGaN) and has N-type conductivity, and the gate region (18) is of gallium nitride with P-type conductivity.

4. The device according to claim 2 or 3, wherein the selector (3) comprises:
- a gate metallization structure (20) on the gate region (18), wherein the metallization levels (M1-M5) comprise a gate metallization level (M1),
- a source field plate (21), wherein the metallization levels (M1-M5) comprise a field plate metallization level (M2).

5. The device according to claim 4, wherein the gate metallization structure (20) and the fuse element (2) are formed in the gate metallization level (M1).

6. The device according to claim 4, wherein the source field plate (21) and the fuse element (40) are formed in the field plate metallization level (M2).

7. The device according to claim 5 or 6, comprising a dielectric structure (22, 23) on the heterostructure (15), the gate region (18) and the gate metallization structure (20), wherein the dielectric structure (22, 23) separates the heterostructure (15) from the fuse element (2; 40) and the source field plate (21) from the gate region (18) and the gate metallization structure (20) and wherein the fuse element (2; 40) is in contact with the dielectric structure (22, 23).

8. The device according to claim 7, wherein the dielectric structure (22, 23) comprises a first dielectric layer (22) on the heterostructure (15) and a second dielectric layer (23) on the first dielectric layer (22) and the fuse element (2; 40) is in contact with at least one of the first dielectric layer (22) and second dielectric layer (23).

9. The device according to claim 8, wherein the fuse element (2) is formed on the first dielectric layer (22) in contact with a portion thereof and is coated by the second dielectric layer (23).

10. The device according to claim 8, comprising a third dielectric layer (24) on the second dielectric layer (23) wherein the fuse element (40) is formed on the second dielectric layer (22) in contact with a portion thereof and is embedded in the third dielectric layer (24).

11. The device according to any of the preceding claims, comprising a write power source (5), wherein the fuse element (2; 40) comprises a narrowing along a conductive track (30, 30a; 41) connecting the write power source (5) to the selector (3).

12. The device according to claim 11, wherein the fuse element (2) extends along a serpentine path and the conductive track (30) has a further narrowing (30a), which has a lowest width in the conductive track (30) and is located at an intermediate portion of the conductive track (30).

13. The device according to any of the preceding claims, comprising a plurality of OTP memory cells (1) identical to each other integrated into the die (101), wherein the OTP memory cells (1) are arranged in rows (R0, ..., Rm-1), each comprising a plurality of bit units (110) and an enable circuit (111), wherein each bit unit (110) comprises a respective one of the OTP memory cells (1) and a respective read/write circuit (112) configured to perform read and write operations on the respective OTP memory cell (1) and selectively operable by the enable circuit (111).

14. The device according to claim 13, wherein, in each row (R0, ..., Rm-1), the enable circuit (111) comprises a read bias circuit (115) forming a read current mirror circuit (117) with the read/write circuit (112) of each bit unit (110), wherein the enable circuit (111) defines a reference branch (117a) of the read current mirror circuit (117), comprising a first enhancement HEMT (118a) and a first depletion HEMT (120a) in series with each other, wherein the read/write circuit (112) of each bit unit (110) defines a respective mirror branch (117b) of the read current mirror circuit (117), coupled to an output (1a) of the respective OTP memory cell (1) and comprising a second enhancement HEMT (118b) and a second depletion HEMT (120b) in series with each other, and wherein the first enhancement HEMT (118a) and the second enhancement HEMT (118b) have respective gate terminals in common and connected to a drain terminal of the first depletion HEMT (120a), wherein the read current mirror circuit (117) comprises a first read enable switch (121a), defined by a further HEMT and connected between the first enhancement HEMT (118a) and the first depletion HEMT (120a), and, for each bit unit (110) of the respective row (R0, ..., Rm-1), a second read enable switch (121b), defined by a further HEMT and connected between the second enhancement HEMT (118b) and the second depletion HEMT (120b) of the respective mirror branch (117b).

15. The device according to claim 13 or 14, comprising a row decoder (103), a command decoder (104) and a shift register (105), all made by using GaN technology, wherein, in each row (R0, ..., Rm-1), the enable circuit (111) comprises a logic module (113) configured to generate local enable signals (W_ENL, R_ENL, S_ENL) as a function of row selection signals (S0, ..., Sm-1) provided by the row decoder (103) and global enable signals (W_EN, R_EN, S_EN) provided by the command decoder (104) and to determine an operating mode of the respective bit units (110) as a function of the local enable signals (W_ENL, R_ENL, S_ENL), wherein each read/write circuit (112) comprises a respective write enable port (123) configured to control the selector (3) of the respective OTP memory cell (1) as a function of the local enable signals (W_ENL, R_ENL, S_ENL) and a write datum (Wi) provided by the shift register (105), wherein the shift register (105) is coupled to each of the rows (R0, ..., Rm-1) and is configured for serial loading of write data (W0, ..., Wn-1) to be written selectively in an addressed one of the rows (R0, ..., Rm-1) during a write operation and for parallel loading of output data (B0, ..., Bn-1) read by an addressed one of the rows (R0, ..., Rm-1) during a read operation.
